# EUROPEAN PATENT APPLICATION

(11) **EP 4 201 944 A1**
(43) Date of publication of application: **28.06.2023**
(21) Application number: 21858190.8
(22) Date of filing: 05.08.2021
(51) Int. Cl.: C07F 7/18, B32B 7/12, B32B 27/00, C09J 11/06, C09J 201/00, H01L 21/02

(54) **SILANE COUPLING AGENT**

(30) Priority: 20.08.2020 JP 2020139427
(71) Applicant: Daicel Corporation, Osaka 530-0011 (JP)
(72) Inventor: TSUJI, Naoko, Tokyo 108-8230 (JP); MAETANI, Shinji, Tokyo 108-8230 (JP)
(74) Representative: Grünecker Patent- und Rechtsanwälte PartG mbB
(86) International application number: PCT/JP2021/029191
(87) International publication number: WO 2022/039043

(57) **Abstract**

Provided is a silane coupling agent with a low viscosity, excellent applicability, and excellent effect of improving adhesion between inorganic matter and organic matter. The silane coupling agent of the present disclosure contains a silicon compound below and water, having a concentration of the silicon compound of from 0.01 to 10 wt.%, the silicon compound: containing a compound (I) represented by Formula (1) and a polycondensate of the compound (I), wherein a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.

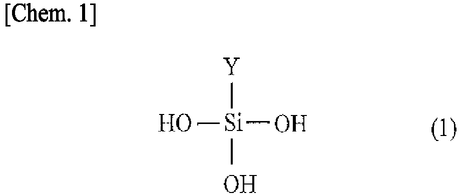

## Description

### Technical Field

The present disclosure relates to a silane coupling agent with excellent effect of improving adhesion between inorganic matter and organic matter and excellent storage stability. The present application claims priority from the Japanese Patent Application No. 2020-139427 filed in Japan on August 20, 2020, the contents of which are incorporated herein by reference.

### Background Art

As a compound that acts to firmly bind inorganic matter and organic matter, each of which has different chemical properties, a compound having a group reactive with organic matter and a silanol group that forms a chemical bond with the surface of inorganic matter (i.e., a silanol compound) or its oligomer is known.

The silanol compound or its oligomer is utilized as a surface modifier or a primer of an inorganic substrate. For example, in wafer-on-wafer (WOW) technology, in which a plurality of wafers on which a circuit is formed is laminated, in chip-on-wafer (COW) technology, in which a plurality of chips is laminated on a wafer on which a circuit is formed, and in chip-on-chip (COC) technology, in which a plurality of chips is laminated, both surfaces of the material to be laminated and the material to laminate are subjected to modification treatment with a silanol compound or its oligomer and then adhered with a permanent adhesive.

However, a silanol compound or its oligomer has a silanol group with excellent reactivity, thus has issues of low storage stability and being prone to gelation as a dehydration condensation reaction proceeds.

Patent Document 1 discloses that a composition containing a silane oligomer obtained by hydrolytic condensation of a silane compound having a reactive functional group and three hydrolyzable groups, such as 3-glycidoxypropyltrimethoxysilane, a hydrolytic polycondensate of tetramethoxysilane, and an alcohol having from 1 to 6 carbons has excellent storage stability. However, for applying to a substrate (especially a thinned substrate, such as a wafer and a chip), the composition has a viscosity too high to be used for the purpose of surface modification and thus has needed to be diluted each time by adding water and/or an alcohol. In addition, the composition has had an issue of a low concentration of silanol groups contributing to the development of adhesion and thus not providing sufficient adhesion when diluted to the extent that good applicability is obtained.

### Citation List

### Patent Document

Patent Document 1: JP 10-251516 A

### Summary of Invention

### Technical Problem

Thus, an object of the present disclosure is to provide a silane coupling agent having a low viscosity, excellent applicability, and effect of strongly adhering inorganic matter and organic matter.

Another object of the present disclosure is to provide a silane coupling agent having excellent applicability and storage stability, and effect of strongly adhering inorganic matter and organic matter.

Yet another object of the present disclosure is to provide an adhesive containing the silane coupling agent and a curable compound and having excellent adhesion and storage stability.

Still another object of the present disclosure is to provide a three-dimensional laminate formed by laminating a wafer(s) and/or a chip(s) using the adhesive.

Yet still another object of the present disclosure is to provide a semiconductor device provided with the three-dimensional laminate.

### Solution to Problem

As a result of diligent research to solve the above issues, the present inventors found that hydrolyzing an alkoxysilane under acidic conditions and under conditions where, either in the absence or presence of an organic solvent, the content of the organic solvent is 0.7 parts by weight per part by weight of a compound represented by Formula (2) below can promote the hydrolysis and a dehydration condensation reaction while preventing gelation and provides a silane coupling agent, that the silane coupling agent has an effect of strongly adhere inorganic matter and organic matter, and that diluting the silane coupling agent with a certain solvent can increase storage stability and applicability while maintaining the high adhesion between inorganic matter and organic matter. The present disclosure has been completed based on these findings.

That is, the present disclosure provides a silane coupling agent containing the following silicon compound and water, in which the silicon compound concentration is from 0.01 to 10 wt.%,
the silicon compound: containing a compound (I) represented by the following Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5, 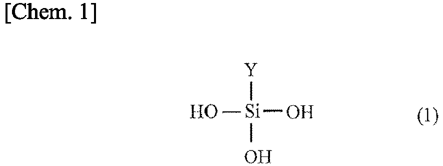
where Y represents a hydrocarbon group having from 1 to 10 carbons and containing a group reactive with organic matter.

The present disclosure also provides the silane coupling agent with a pH of 4 or lower.

The present disclosure also provides the silane coupling agent containing a solvent with the following properties,
the solvent: having an evaporation rate of from 10 to 400 when an evaporation rate of butyl acetate is taken as 100.

The present disclosure also provides the silane coupling agent further containing a solvent with the following properties,
the solvent: having an evaporation rate of from 10 to 400 when an evaporation rate of butyl acetate is taken as 100, and an SP value of 6 to 15 at 25°C.

The present disclosure also provides the silane coupling agent that is a surface modifier.

The present disclosure also provides a method of manufacturing a silane coupling agent, the method including:
by hydrolyzing a compound represented by Formula (2) obtaining a compound represented by Formula (1) under a condition of pH 4 or lower and under conditions where, either in the absence or presence of an organic solvent, a content of the organic solvent is 0.7 parts by weight or less per part by weight of the compound represented by Formula (2): 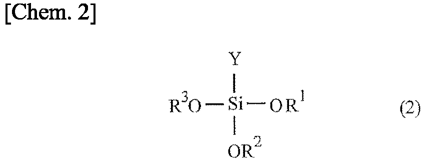
where in Formula (2), Y represents a hydrocarbon group having from 1 to 10 carbons and containing a group reactive with organic matter, and OR¹ to OR³ are the same or different and each represent a hydrolyzable group, 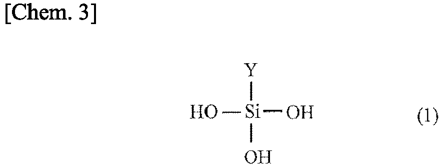
where in Formula (1), Y is the same as described above; and
the method including, by subjecting the resulting compound represented by Formula (1) to a polycondensation reaction, obtaining the silane coupling agent.

The present disclosure also provides an adhesive containing the following silicon compound and a curable compound:
the silicon compound: containing a compound (I) represented by the following Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5: 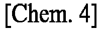 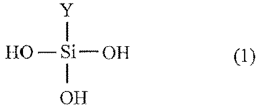
where Y represents a hydrocarbon group having from 1 to 10 carbons and containing a group reactive with organic matter.

The present disclosure also provides the adhesive, in which a content of the silicon compound is from 0.01 to 40 parts by weight per 100 parts by weight of the curable compound.

The present disclosure also provides a three-dimensional laminate having a configuration in which a wafer and a wafer, a chip and a chip, or a wafer and a chip are laminated via the adhesive described above.

The present invention also provides a semiconductor device provided with the three-dimensional laminate.

### Advantageous Effects of Invention

The silane coupling agent according to the present disclosure has a high silanol group concentration and thus can strongly adhere inorganic matter and organic matter even at low concentrations. In addition, the silane coupling agent has excellent storage stability and can prevent gelation over a long period of time.

Furthermore, to bond adherents, an adhesive has needed to be applied to both surfaces to be bonded together in the art, but using an adhesive obtained by mixing a curable compound with the silane coupling agent of the present disclosure enables to strongly adhere and fix adherents even by applying the adhesive to one of the surfaces and then bonding adherents together, providing excellent workability.

Using the silane coupling agent or the adhesive in a semiconductor chip lamination technique, such as a wafer-on-wafer (WOW) method, a chip-on-wafer (COW) method, or a chip-on-chip (COC) method, can efficiently laminate wafers or chips that are extremely reduced in size and thickness and strongly adhere and fix them and can manufacture a three-dimensional laminate with good yield.

### Brief Description of Drawings

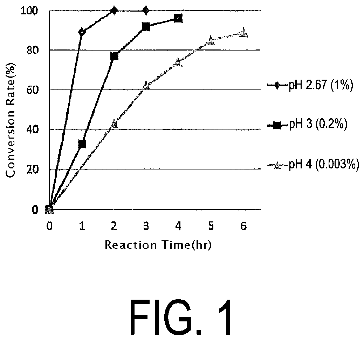

FIG. 1 is a graph indicating effect of pH on a conversion rate in a hydrolysis reaction and a polycondensation reaction under conditions of a temperature of 50°C and 6 eq of water.

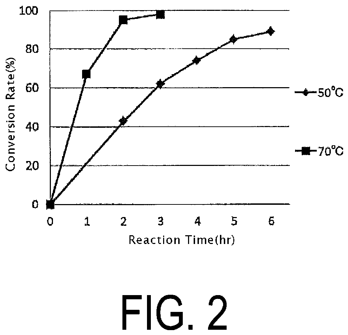

FIG. 2 is a graph indicating effect of reaction temperature on a conversion rate in a hydrolysis reaction and a polycondensation reaction under conditions of pH 4 and 6 eq of water.

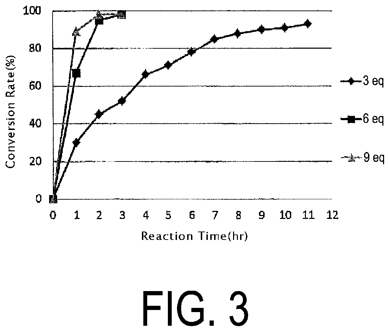

FIG. 3 is a graph indicating effect of water amount on a conversion rate in a hydrolysis reaction and a polycondensation reaction under conditions of pH 4 and a temperature of 70°C.
FIG. 4 is spectrums indicating a Si-NMR measurement result (A) of a silane coupling agent obtained in Example 1 and a Si-NMR measurement result (B) of a silane coupling agent obtained in Comparative Example 2.
FIG. 5 is graphs indicating storage stability at 5°C and 40°C of a silane coupling agent (+ ethanol) obtained in Example 1 and a silane coupling agent (+ PGMEA) obtained in Example 2.

### Description of Embodiments

### Silane coupling agent

A silane coupling agent of the present disclosure contains a silicon compound below and water, where the silicon compound concentration is from 0.01 to 10 wt.%,
the silicon compound: containing a compound (I) and its polycondensate, where a ratio of contents of the compound (I) to a compound (i.e., a compound (II)), [compound (I)/compound (II); weight ratio], the compound being a condensate of the compound (I) and having a weight average molecular weight of from 200 to 10000 calibrated with a polystyrene standard, is from 1/99 to 95/5, where the compound (I) is a compound represented by the following Formula (1):

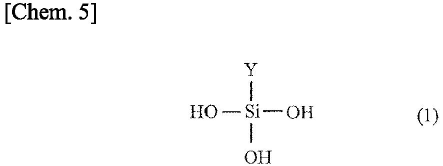

In Formula (1) above, Y represents a hydrocarbon group having from 1 to 10 carbons and containing a group reactive with organic matter.

The group reactive with organic matter includes an addition-reactive group, substitution-reactive group, or polymerization-reactive group (radical-polymerization-reactive group or cationic-polymerization-reactive group) with organic matter, and examples include an amino group, an epoxy group, a (meth)acryloyloxy group, a vinyl group, a mercapto group, and an isocyanurate group. For example, in adhering inorganic matter (e.g., such as a silicon wafer or glass) using an adhesive, when the silane coupling agent of the present disclosure is used to improve the adhesion between the inorganic matter and the adhesive, the group reactive with organic matter is preferably a group with excellent reactivity with the adhesive; when the adhesive contains an epoxy resin as a curable compound, the group reactive with an organic matter is preferably an epoxy group; and when the adhesive uses an acrylic resin as a curable compound, the group reactive with organic matter is preferably a (meth)acryloyloxy group.

The epoxy group includes groups represented by Formulas (e-1) to (e-3) below, where in the formulas below, R represents a hydrogen atom or a C₁₋₃ alkyl group.

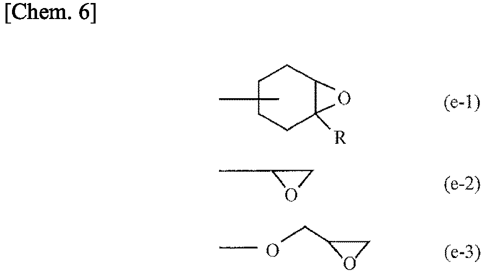

The hydrocarbon group includes aliphatic hydrocarbon groups, alicyclic hydrocarbon groups, aromatic hydrocarbon groups, and groups obtained by bonding these.

Examples of the aliphatic hydrocarbon group include alkyl groups having approximately from 1 to 10 (preferably from 1 to 3) carbons, such as a methyl group, an ethyl group, a propyl group, an isopropyl group, a butyl group, an isobutyl group, an s-butyl group, a t-butyl group, a pentyl group, a hexyl group, and a decyl group; alkenyl groups having approximately from 2 to 10 (preferably 2 or 3) carbons, such as a vinyl group, an allyl group, and a 1-butenyl group; and alkynyl groups having approximately from 2 to 10 (preferably 2 or 3) carbons, such as an ethynyl group and a propynyl group.

The alicyclic hydrocarbon group is preferably a C₃₋₁₀ alicyclic hydrocarbon group, and examples include approximately from 3 to 10-membered (preferably from 5- to 8-membered) cycloalkyl groups, such as a cyclopropyl group, a cyclobutyl group, a cyclopentyl group, a cyclohexyl group, and a cyclooctyl group; approximately from 3- to 10-membered (preferably from 5- to 8-membered) cycloalkenyl groups, such as a cyclopentenyl group and a cyclohexenyl group; and bridged cyclic hydrocarbon groups, such as a perhydronaphthalen-1-yl group, a norbornyl group, an adamantyl group, and a tricyclo[5.2.1.0^{2,6}]decan-8-yl group.

The aromatic hydrocarbon group is preferably a C₆₋₁₀ aromatic hydrocarbon group, and its examples include a phenyl group and a naphthyl group.

The polycondensate of the compound (I) is a resin (oligomer or polymer) having a siloxane (Si-O-Si) backbone. Examples of the structure of the resin include cyclic, chain (linear and branched), cage, and ladder structures.

Among them, the polycondensate preferably has a chain (particularly, a linear chain) structure in terms of having excellent solubility in solvents and being able to be applied by a spin coating method or the like when used to modify the surface of a substrate or the like and is particularly preferably a compound represented by Formula (3) below. In the following formula, Y is the same as described above, n is the number of a repeating unit(s) indicated in the parenthesis and indicates an integer of 1 or more, and n + 1 Y's may be the same or different.

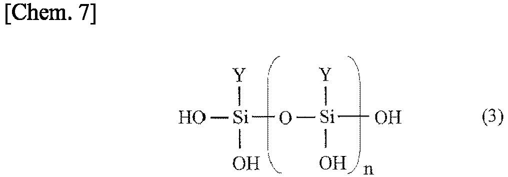

The silane coupling agent contains as silicon compounds the compound (I) and the compound (II) that is a polycondensate of the compound (I) (preferably a compound represented by Formula (3) above) and has a weight average molecular weight of from 200 to 10000 calibrated with a polystyrene standard.

The ratios of contents of the compound (I) to the compound (II), [compound (I)/compound (II); weight ratio], is from 1/99 to 95/5, and the lower limit is preferably 3/97, more preferably 5/95, particularly preferably 10/90, and most preferably 20/80 in terms of preventing formation of a gel product. In addition, the upper limit is preferably 93/7 and particularly preferably 90/10 in terms of improving the adhesion.

If the content of the compound (I) exceeds the above range (in other words, if the content of the compound (II) is below the above range), the adhesion would tend to decrease, and if the content of the compound (II) exceeds the above range (i.e., if the content of the compound (I) is below the above range), a gel product would tend to be easily formed.

The weight average molecular weight calibrated with a polystyrene standard of the silicon compound contained in the silane coupling agent is, for example, from 150 to 9500. The lower limit is preferably 200, more preferably 230, and particularly preferably 250. In addition, the upper limit is preferably 8000, more preferably 7000, even more preferably 5000, still more preferably 2000, yet more preferably 1000, particularly preferably 800, and most preferably 600, and especially preferably 550 in terms of a high silanol group concentration and being able to exhibit the improving effect on the adhesion between inorganic matter and organic matter at lower concentrations. Furthermore, the molecular weight distribution (Mw/Mn) of the silicon compound is, for example, from 1.1 to 4.0, preferably from 1.1 to 2.0, and particularly preferably from 1.1 to 1.5.

The silane coupling agent according to the present disclosure may contain a silicon compound having another structure as a silicon compound in addition to the compound (I) and the compound (II); for example, the silane coupling agent may contain a disilanol represented by Formula (1') below and/or a monosilanol represented by Formula (1") below together with the compound (I) (i.e., trisilanol). Y in the formulas below is the same as described above.

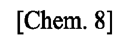

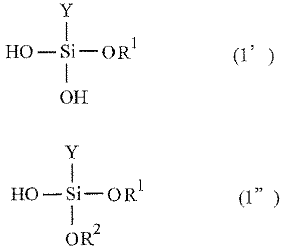

In the formulas above, OR¹ and OR² are the same or different and each represent a hydrolyzable group. Examples of the hydrolyzable group include C₁₋₅ alkoxy groups and C₁₋₅ acyloxy groups. Thus, R¹ and R² are, for example, the same or different and are a C₁₋₅ alkyl group or a C₁₋₅ acyl group.

In addition, the silane coupling agent may contain, together with the compound (II), a compound (i.e., compound (II')) that is a polycondensate of the compound (I) and has a weight average molecular weight less than the lower limit of the weight average molecular weight (e.g., 200) of the compound (II) calibrated with a polystyrene standard and/or a compound (i.e., compound (II")) that is a polycondensate of the compound (I) and has a weight average molecular weight greater than the upper limit of the weight average molecular weight (e.g., 10000) of the compound (II) calibrated with a polystyrene standard, but in terms of a high silanol group concentration and being able to exhibit the improving effect on the adhesion between inorganic matter and organic matter at lower concentrations and in terms of excellent storage stability, the total content of the compound (II') and the compound (II") is, for example, preferably 30 wt.% or less, more preferably 20 wt.% or less, particularly preferably 10 wt.% or less, most preferably 5 wt.% or less, and especially preferably 1 wt.% or less.

Furthermore, in the silane coupling agent of the present disclosure, a compound represented by Formula (2) below may be contained (e.g., may remain without being hydrolyzed), but in terms of being able to exhibit the improving effect on the adhesion between inorganic matter and organic matter at low concentrations, the content of the compound represented by Formula (2) below is, for example, preferably 50 wt.% or less, more preferably 40 wt.% or less, particularly preferably 30 wt.% or less, and most preferably 25 wt.% or less of all silicon compounds contained in the silane coupling agent. Y, R¹, and R² in the following formula are the same as described above.

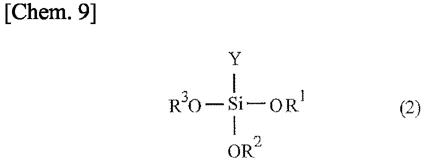

In the formula above, OR³ represents a hydrolyzable group. Examples of the hydrolyzable group include C₁₋₅ alkoxy groups and C₁₋₅ acyloxy groups. Thus, R³ is, for example, the same or different and is a C₁₋₅ alkyl group or a C₁₋₅ acyl group.

The silane coupling agent is preferably acidic in terms of excellent storage stability, and the pH of the silane coupling agent is, for example, preferably 4 or lower (i.e., the pH is 4 or more acidic than 4), more preferably from 2 to 4, and particularly preferably from 3 to 4. If the pH of the silane coupling agent is out of the above range to the basic side, the dehydration condensation reaction of the silicon compound in the silane coupling agent would proceed, and the silicon compound would gel. Thus, this would make the application by a spin coating method or the like difficult when the silane coupling agent is used to modify the surface of a substrate or the like and thus is not preferred. On the other hand, if the pH of the silane coupling agent is out of the above range to the acidic side, the reactive group would be prone to decomposition, and thus this is not preferred.

The viscosity of the silane coupling agent is, for example, preferably approximately from 1 to 300 mPa•s in terms of having good applicability. The viscosity can be measured using a digital viscometer (model No. "DVU-EII", available from Tokyo Keiki Inc.) under conditions of a rotor of standard 1° 34' x R24, a temperature of 25°C, and a rotation speed of 0.5 to 10 rpm.

For the silane coupling agent, water or a solvent can be used as a diluent. A volatile solvent is preferably used as the solvent. A volatile solvent quickly volatilizes after application of the silane coupling agent containing a volatile solvent, reducing the fluidity of the silane coupling agent. Thus, this enables the silane coupling agent to be applied thickly, the silanol group concentration in the coating to increase, and the improving effect on the adhesion between inorganic matter and organic matter to increase.

The solvent is, for example, preferably a solvent with an evaporation rate of from 10 to 400 when an evaporation rate of butyl acetate under certain temperature and pressure is taken as 100. In addition, in terms of obtaining the effect of improving the storage stability, the lower limit of the evaporation rate is more preferably 20, particularly preferably 50, most preferably 100, and especially preferably 150, and the upper limit of the evaporation rate is more preferably 350, particularly preferably 300, and most preferably 250. The evaporation rate of the solvent is, for example, an evaporation rate under normal temperature (preferably 25°C) and normal atmospheric pressure.

In addition, the solvent preferably used is a solvent with an SP value (according to the Fedors method) of 6 to 15 (more preferably of 9 to 15, particularly preferably of 9 to 14, and most preferably of 10 to 13) at 25°C in that the solvent caps the silanol group and prevents the progress of the dehydration condensation reaction of the silicon compound, and this provides the effect of further improving the storage stability.

The solvent particularly preferably used is a solvent with an evaporation rate in the above range when an evaporation rate of butyl acetate is taken as 100 and with an SP value in the above range at 25°C in terms of being able to increase both the adhesion between inorganic matter and organic matter and the storage stability.

Examples of the solvent include aliphatic alcohols, such as ethanol, 1-propanol, 1-butanol, and 1-pentanol; and glycol ether esters, such as propylene glycol methyl ether acetate (PGMEA). One of these can be used individually, or two or more in combination.

Among them, in terms of excellent workability and handling properties during application and increasing both the improving effect on the adhesion between inorganic matter and organic matter and the storage stability, the solvent is preferably an aliphatic alcohol, particularly preferably a monohydric aliphatic alcohol, particularly preferably a monohydric C₂₋₆ aliphatic alcohol, and especially preferably ethanol.

The silane coupling agent has excellent storage stability, and the increase value of the weight average molecular weight when the silane coupling agent is stored at 5°C for 30 days is, for example, 500 or less, preferably 200 or less, particularly preferably 100 or less, and most preferably 50 or less.

The silane coupling agent has excellent storage stability in high-temperature environments, and the increase value of the weight average molecular weight when the silane coupling agent is stored at 40°C for 30 days is, for example, 2000 or less, preferably 1500 or less, particularly preferably 1000 or less, and most preferably 700 or less.

The silane coupling agent of the present disclosure has a low viscosity and excellent applicability. In addition, the silane coupling agent has the effect of improving the adhesion between inorganic matter and organic matter. Thus, applying the silane coupling agent to the surface of inorganic matter (e.g., such as silicon wafer or glass) improves the adhesion with an adhesive, which is organic matter. Thus, the silane coupling agent can be suitably used as a surface modifier for inorganic matter.

### Method of manufacturing silane coupling agent

The silane coupling agent can be manufactured through steps [I] and [II] below.

Step [I]: hydrolyzing a compound represented by Formula (2) and obtaining a compound represented by Formula (1) under a condition of pH 4 or lower and under conditions where, either in the absence of presence of an organic solvent, a content of the organic solvent is 0.7 parts by weight or less per part by weight of the compound represented by Formula (2): 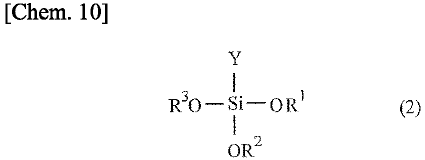
where in Formula (2), Y represents a hydrocarbon group having from 1 to 10 carbons and containing a group reactive with organic matter, and OR¹ to OR³ are the same or different and each represent a hydrolyzable group, 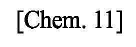 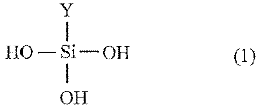
where in Formula (1), Y is the same as described above.

Step [II]: subjecting the compound represented by Formula (1) obtained through step [I] to a polycondensation reaction.

These steps [I] and [II] will be described in detail below.

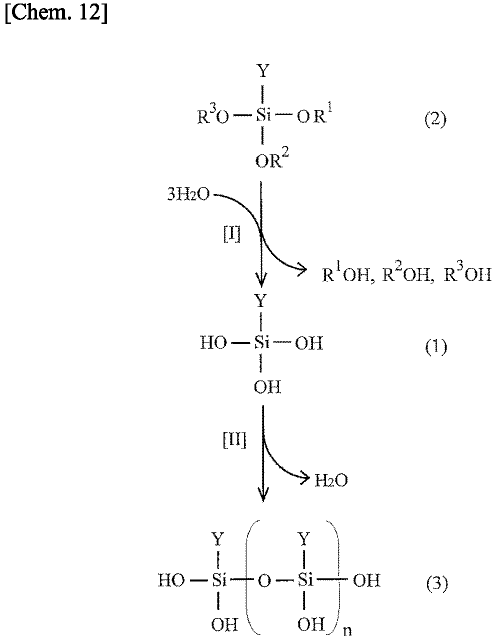

In the formulas above, R¹, R², R³, Y, and n are the same as described above.

Examples of the compound represented by Formula (2) in which Y in the formula is a hydrocarbon group having from 1 to 10 carbons and containing an epoxy group include 2-(3,4-epoxycyclohexyl)ethyltrimethoxysilane, 3-glycidoxypropyltrimethoxysilane, 3-glycidoxypropylmethyldimethoxysilane, 3-glycidoxypropylmethyldiethoxysilane, and 3-glycidoxypropyltriethoxysilane.

Examples of the compound represented by Formula (2) in which Y in the formula is a hydrocarbon group having from 1 to 10 carbons and containing a (meth)acryloyloxy group include 3-(meth)acryloyloxypropylmethyldimethoxysilane, 3-(meth)acryloyloxypropyltrimethoxysilane, 3-(meth)acryloyloxypropylmethyldiethoxysilane, and 3-(meth)acryloyloxypropyltriethoxysilane.

The step [I] includes, by carrying out a hydrolysis reaction of the compound represented by Formula (2), obtaining the compound represented by Formula (1). The amount of water to be used is, for example, from 0.6 to 12 mol per mol of the compound represented by Formula (2).

The hydrolysis reaction is carried out under conditions of pH 4 or lower (preferably pH 2 to 4 and particularly preferably pH 3 to 4).

In addition, the hydrolysis reaction is carried out under conditions where, in the absence of an organic solvent or in the presence of an organic solvent, a content of the organic solvent is 0.7 parts by weight or less per part by weight of the compound represented by Formula (2) below.

Examples of the organic solvent include monohydric aliphatic alcohols, such as ethanol, 1-propanol, 1-butanol, and 1-pentanol; and glycol ether esters, such as propylene glycol methyl ether acetate.

The upper limit of the content of the organic solvent (the total amount when two or more organic solvents are contained) is 0.7 parts by weight or greater, preferably 0.5 parts by weight or greater, particularly preferably 0.3 parts by weight or greater, and particularly preferably 0.2 parts by weight per part by weight of the compound represented by Formula (2) above.

The hydrolysis reaction is carried out under the above conditions, and thus this can promote the progress of the hydrolysis reaction of the compound represented by Formula (2), increase the production amount of silanol groups, and efficiently produce the compound represented by Formula (1).

The presence of the organic solvent (particularly the above polar organic solvent) in an amount greater than the above range in the reaction system during the hydrolysis reaction would inhibit the progress of the hydrolysis reaction of the compound represented by Formula (2), making it difficult to efficiently produce the compound represented by Formula (1).

In addition, if the pH in the reaction system during the hydrolysis reaction exceeds 4 and shifts to the alkaline side, the progress of the hydrolysis reaction of the compound represented by Formula (2) would be inhibited, and this would reduce the yield of compound (II) and increase the by-production rate of the compound (II') and/or the compound (II"). As a result, the formation of a three-dimensional cross-linking structure would proceed, and the product would tend to gel. On the other hand, if the pH is excessively reduced, the reactive group would tend to decompose easily.

The step [II] includes dehydrating and condensing the compound represented by Formula (1) obtained through the step [I] and obtaining the compound represented by Formula (3) formed by dehydration condensation of (n + 1) compounds represented by Formula (1).

Subjecting the compound represented by Formula (1) to a dehydration condensation reaction under conditions of pH 4 or lower (preferably pH 2 to 4 and particularly preferably pH 3 to 4) allows a reaction forming a two-dimensional network to proceed more selectively than a reaction three-dimensionally forming a cross-linked structure. This can increase the production ratio of the compound (II) while preventing gelation and provides a silane coupling agent easy to apply by a spin coating method or the like and having excellent adhesion between inorganic matter and organic matter.

In addition, the dehydration condensation reaction may be carried out in the presence of an organic solvent, but for example, the reactions of the step [I] and the step [II] may be carried out in one-pot, or the step [II] may be carried out under the same conditions as those of the step [I], that is, under conditions where, in the absence of an organic solvent or in the presence of an organic solvent, a content of the organic solvent is 0.7 parts by weight or less per part by weight of the compound represented by Formula (2) below.

The reaction atmosphere in the steps [I] and [II] is any atmosphere that does not inhibit the reaction and not particularly limited and may be, for example, any of an air atmosphere, a nitrogen atmosphere, and an argon atmosphere.

The reaction temperature in the steps [I] and [II] is, for example, approximately from 40 to 85°C. The reaction time is, for example, approximately 20 hours or shorter. In addition, the reaction can be carried out by any method, such as a batch method, a semi-batch method, and a continuous method. The progress of the dehydration condensation reaction can be stopped by lowering the temperature in the reaction system to 30°C or lower. Alternatively, the dehydration condensation reaction may be stopped by a method of adding one or two or more solvents to reduce the concentration in the reaction system.

Examples of the solvent include the same examples as those that can be utilized as a diluent for the silane coupling agent.

After completion of the reaction in the step [II], the resulting reaction product can be separated and purified by a separation means, such as filtration, concentration, distillation, extraction, crystallization, adsorption, recrystallization, or column chromatography; or a separation means in combination of these.

### Adhesive

An adhesive of the present disclosure contains a silicon compound below and a curable compound:
the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.

The silicon compound is the same as the silicon compound contained in the silane coupling agent described above.

The curable compound includes a thermoplastic resin and a thermosetting (or photo-curable) resin. The curable compound can be appropriately selected according to the application. For example, a thermosetting (or photo-curable) resin is preferably used in the application for manufacturing a three-dimensional laminate formed by laminating a wafer and a wafer, a chip and a chip, or a wafer and a chip.

The thermosetting (or photo-curable) resin is a compound that is irreversibly cured by heating (or light irradiation), and examples include an epoxy resin and an acrylic resin. One of these can be used individually, or two or more in combination.

Examples of the epoxy resin include compounds containing an alicyclic epoxy group (group represented by Formula (e-1) described above), such as 3,4-epoxycyclohexylmethyl(3,4-epoxy)cyclohexanecarboxylate, (3,4,3',4'-diepoxy)bicyclohexyl, bis(3,4-epoxycyclohexylmethyl) ether, 1,2-epoxy-1,2-bis(3,4-epoxycyclohexan-1-yl)ethane, 2,2-bis(3,4-epoxycyclohexan-1-yl)propane, and 1,2-bis(3,4-epoxycyclohexan-1-yl)ethane; alicyclic glycidyl ethers, such as hydrogenated bisphenol A-type diglycidyl ether, hydrogenated bisphenol F-type diglycidyl ether, hydrogenated biphenol-type diglycidyl ether, hydrogenated phenol novolac-type diglycidyl ether, and hydrogenated cresol novolac-type diglycidyl ether; and compounds containing a glycidyl ether group (group represented by Formula (e-3) described above), such as aromatic glycidyl ethers, such as bisphenol A-type diglycidyl ether, bisphenol F-type diglycidyl ether, biphenol-type diglycidyl ether, phenol novolac-type diglycidyl ether, and cresol novolac-type diglycidyl ether.

The epoxy resin also includes an epoxy group-containing polyorganosilsesquioxane in addition to the above compound. The epoxy group includes groups represented by Formulas (e-1) to (e-3) described above.

The epoxy group-containing polyorganosilsesquioxane is a compound having a main chain backbone made of siloxane bonds and a group containing an epoxy group bonded to the main chain backbone.

The epoxy group-containing polyorganosilsesquioxane includes those having a structure of various types, such as a ladder-type structure, a complete cage-type structure, an incomplete cage-type structure, and a random-type structure. Among them, a silsesquioxane having an incomplete cage-type structure is preferred in terms of being able to form a cured product with high hardness.

The epoxy group-containing polyorganosilsesquioxane having an incomplete cage-type structure contains a constituent unit represented by Formula (S1) below:

[R^{a}SiO_{3/2}] (S1)

where in Formula (S1), R^{a} represents a group containing an epoxy group, an aryl group, an aralkyl group, a cycloalkyl group, an alkyl group, an alkenyl group, or a hydrogen atom; and
a constituent unit represented by Formula (S2) below:

   [R^{a}SiO_{2/2}(OR^{b})] (S2)
where in Formula (S2), R^{a} is the same as described above, and R^{b} represents a hydrogen atom or an alkyl group having from 1 to 4 carbons, and
at least one in the total amount of the constituent units represented by Formula (S1) above and the constituent units represented by Formula (S2) above is a constituent unit in which R^{a} contains an epoxy group.

The constituent unit represented by Formula (S1) above is referred to as a T3 form. In addition, the constituent unit represented by Formula (S2) above is referred to as a T2 form. Both of these constituent units are T units.

Examples of the aryl group include aryl groups having from 6 to 10 carbons, such as a phenyl group and a naphthyl group.

Examples of the aralkyl group include aralkyl groups having from 7 to 12 carbons, such as a benzyl group and a phenethyl group.

Examples of the cycloalkyl group include cycloalkyl groups having from 3 to 6 carbons, such as a cyclobutyl group, a cyclopentyl group, and a cyclohexyl group.

Examples of the alkyl group include linear or branched alkyl groups having from 1 to 6 carbons, such as a methyl group, an ethyl group, a propyl group, an n-butyl group, an isopropyl group, an isobutyl group, an s-butyl group, a t-butyl group, and an isopentyl group.

Examples of the alkenyl group include linear or branched alkenyl groups having from 2 to 6 carbons, such as a vinyl group, an allyl group, and an isopropenyl group.

Examples of the alkoxy group having from 1 to 4 carbons include a methoxy group, an ethoxy group, a propoxy group, an isopropyloxy group, a butoxy group, and an isobutyloxy group.

The epoxy group-containing polyorganosilsesquioxane may contain a constituent unit that is a constituent unit represented by Formula (S1) or (S2) above where R^{a} in the formula is a substituted or unsubstituted group (e.g., phenyl group) together with a constituent unit that is a constituent unit represented by Formula (S1) or (S2) above where R^{a} in the formula is a group containing an epoxy group.

The T3 form/the T2 form (molar ratio), that is, the ratio of contents of the constituent units represented by Formula (S1) and the constituent units represented by Formula (S2) (the former/the latter; molar ratio) is, for example, from 5 to 500. The lower limit of the molar ratio is preferably 7, particularly preferably 8, most preferably 9, and especially 10 in terms of obtaining an effect of improving hardness and scratch resistance of the resulting cured product. The upper limit of the molar ratio is preferably 50, particularly preferably 30, most preferably 20, and especially 15. The molar ratio can be determined, for example, by ²⁹Si-NMR spectrum measurement. In the ²⁹Si-NMR spectrum, a silicon atom in the T3 form and a silicon atom in the T2 form have peaks at different positions, and thus the molar ratio is determined by calculating the ratio of the integrated values of the respective peaks.

The ²⁹Si-NMR spectrum measurement can be measured, for example, with the following instrument and conditions.
Measuring instrument: "JNM-ECA500NMR (trade name)" available from JEOL Ltd.
Solvent: deuteriochloroform
Cumulative number: 1800 times
Measurement temperature: 25°C

The monomer component constituting the acrylic resin includes an alkyl (meth)acrylate and a functional group-containing monomer. The monomer component may further include one or two or more types of monomers copolymerizable with an alkyl (meth)acrylate and/or a functional group-containing monomer.

Examples of the alkyl (meth)acrylate include alkyl (meth)acrylates with an alkyl group having from 1 to 20 carbons, such as ethyl (meth)acrylate, butyl (meth)acrylate, 2-ethylhexyl (meth)acrylate, and isononyl (meth)acrylate.

Examples of the functional group-containing monomer include carboxyl group-containing monomers or their anhydrides, such as (meth)acrylic acid, maleic acid, and fumaric acid; hydroxyl group-containing monomers, such as hydroxyethyl (meth)acrylate; epoxy group-containing monomers, such as glycidyl (meth)acrylate and methyl glycidyl (meth)acrylate; cyano group-containing monomers, such as acrylonitrile (meth)acrylate; and amide group-containing monomers, such as N-hydroxyethyl acrylamide.

The adhesive of the present disclosure may contain one or two or more additional components besides the silicon compound and the curable compound within a range that does not impair the properties of the present disclosure. Examples of the additional component include cationic polymerization initiators, cross-linkers, cross-linking accelerators, tackifiers (e.g., such as rosin-derivative resins, polyterpene resins, petroleum resins, and oil-soluble phenolic resins), anti-aging agents, bulking agents, ultraviolet absorbers, antioxidants, chain transfer agents, plasticizers, softeners, surfactants, antistatic agents, water, solvents, and fillers. Examples of the solvent include the same examples as those that may be contained in the silane coupling agent described above.

The adhesive containing an epoxy resin as a curable compound preferably further contains a cationic polymerization initiator.

The cationic polymerization initiator includes a photo or thermal cationic polymerization initiator.

Examples of the cationic polymerization initiator include onium salts containing a sulfonium ion or an iodonium ion as a cationic moiety and PF₆⁻, SbF₆⁻, or the like as an anionic moiety.

The amount of the cationic polymerization initiator to be used is, for example, from 0.1 to 20 parts by weight per 100 parts by weight of the epoxy compound.

The adhesive containing an acrylic resin as a curable compound preferably further contains a cross-linker.

Examples of the cross-linker that can be suitably used include isocyanate-based cross-linkers, such as 1,6-hexamethylene diisocyanate and isophorone diisocyanate; and epoxy-based cross-linkers, such as 1,3-bis(N,N-diglycidylaminomethyl)cyclohexane. The content of the cross-linker is, for example, approximately from 0.05 to 2 parts by weight per 100 parts by weight of the total amount of monomer components forming the acrylic polymer.

The adhesive preferably contains an epoxy resin as a curable compound when used in the application requiring heat resistance, curability in the presence of oxygen, and dimensional stability. In addition, the adhesive preferably contains an acrylic resin as a curable compound when used in the application requiring fast curing properties.

The adhesive contains the silicon compound and the curable compound, and the silicon compound has a high silanol group concentration. Thus, the adhesive can exhibit excellent adhesion even at low concentrations. The content of the silicon compound in the adhesive is, for example, from 0.01 to 40 parts by weight, preferably from 0.03 to 20 parts by weight, particularly preferably from 0.05 to 10 parts by weight, and most preferably from 0.1 to 5 parts by weight per 100 parts by weight of the curable compound (preferably an epoxy resin or an acrylic resin).

The adhesive may further contain an additional component besides the silicon compound and the curable compound. Examples of the additional component include water, solvents, and fillers. Examples of the solvent include the same examples as those that may be contained in the silane coupling agent described above.

When two inorganic matters are bonded together in the art, the bonding surfaces of the two inorganic matters have been modified in advance using a silane coupling agent or the like, and then these have been bonded together using an adhesive. However, when the adhesive of the present disclosure is used, the adhesive is directly applied to the bonding surface of one of the two inorganic matters, and then the two inorganic matters are bonded together. This allows silanol groups of the silicon compound contained in the adhesive to form Si-O-Si bonds together with hydroxyl groups in the inorganic matters and simultaneously allows reactive groups in the silicon compound, the reactive groups reactive with organic matter, to react with the adhesive. Thus, this can strongly bond the two inorganic matters by a very simple method.

In addition, the adhesive may contain the silicon compound and the curable compound and may be a one-part adhesive formed by mixing these compounds in advance or may be a two-part adhesive for which these compounds are separately stored and mixed for use. Among them, in the present disclosure, a one-part adhesive is preferably used in terms of excellent workability. The adhesive contains a silicon compound with excellent storage stability, and thus this can prevent gelation over a long period of time even when the adhesive is used as a one-part adhesive, allowing stable storage.

### Three-dimensional laminate

A three-dimensional laminate of the present disclosure has a configuration in which a wafer and a wafer, a chip and a chip, or a wafer and a chip are laminated via the adhesive (specifically a cured product of the adhesive).

Among the three-dimensional laminates, the structure in which a wafer and a wafer are laminated can be manufactured, for example, by a method (1) or (2) below.
1: When a one-part adhesive or an adhesive prepared by mixing liquids of a two-part adhesive is used as the adhesive, the adhesive is applied to the bonding surface of one of the wafers to bond the wafers together, and then the adhesive is cured.
2: When a two-part adhesive is used as the adhesive, a first liquid containing the silicon compound is applied to the bonding surfaces of both wafers, then these are bonded together with a second liquid containing a permanent adhesive, and then the permanent adhesive is cured.

The adhesive can be cured by a method according to the type of adhesive. For example, when an ultraviolet-curable adhesive is used, the adhesive can be cured by irradiation with ultraviolet light, and when a thermosetting adhesive is used, the adhesive can be cured by performing heat treatment.

Among the three-dimensional laminates, the structure in which a chip and a chip or a wafer and a chip are laminated can also be manufactured by a method similar to the above methods.

The three-dimensional laminate is subjected to processes, such as forming a through electrode (e.g., TSV), then dicing the laminate into individual pieces, placing the piece to a wiring substrate to attach an electrode, and sealing with a resin or the like.

### Semiconductor device

A semiconductor device of the present disclosure is provided with the three-dimensional laminate. Examples of the semiconductor device of the present disclosure include mobile devices, such as smartphones and tablets; servers, workstations, in-vehicle computers, personal computers, communication devices, photographing devices, and image display devices.

The semiconductor device of the present disclosure is provided with the three-dimensional laminate and thus can accommodate increasing densification, increasing speed, and reducing power consumption.

Each of the configurations, their combinations, and the like of the present disclosure above is an example, and addition, omission, substitution, and change of the configuration can be appropriately made without departing from the gist of the present disclosure. In addition, the present disclosure is not limited by the embodiments and is limited only by the claims.

### Examples

Hereinafter, the present disclosure will be described more specifically with reference to examples, but the present disclosure is not limited by these examples.

### Example 1: Preparation of silane coupling agent

To a reaction vessel were placed 3-glycidoxypropyltriethoxysilane and 0.003 wt.% acetic acid aqueous solution and heated at 70°C for 3 hours under conditions of pH 4, 6 eq of water. As a result, a hydrolysis reaction and a polycondensation reaction proceeded with a conversion rate of 100%.

The heat treatment was then stopped, 39.9 g of ethanol was added to 5 g of the resulting crude product, and a silane coupling agent (1) (viscosity at 25°C and a rotation speed of 0.5 rpm: < 5 mPa•s) was obtained.

The evaporation rate of ethanol is 203 when the evaporation rate of butyl acetate is taken as 100, and the SP value of ethanol is 12.7 at 25°C.

Compound (I)/compound (II) (weight ratio) in the silane coupling agent (1) was determined by GPC measurement.

In addition, the weight average molecular weight (Mw) and molecular weight distribution (Mw/Mn) calibrated with a polystyrene standard of the silicon compound in the silane coupling agent (1) were determined by GPC measurement.

The GPC measurement was performed under the following conditions.
Measuring instrument: "LC-20AD (trade name)" available from Shimadzu Corporation
Column: Shodex KF-801 x 2 + KF-802 x 1 + KF-803 x 1 (available from Showa Denko K.K.)
Measurement temperature: 40°C
Eluent: THF
Sample concentration: from 0.1 to 0.2 wt.%
Flow rate: 1 mL/min
Detector: UV-VIS detector ("SPD-20A (trade name)" available from Shimadzu Corporation)

### Example 2: Preparation of silane coupling agent

A silane coupling agent (2) was obtained in the same manner as in Example 1 except that PGMEA was used instead of ethanol.

The evaporation rate of PGMEA is 19 when the evaporation rate of butyl acetate is taken as 100, and the SP value of PGMEA at 25°C is 8.7.

### Example 3: Preparation of silane coupling agent

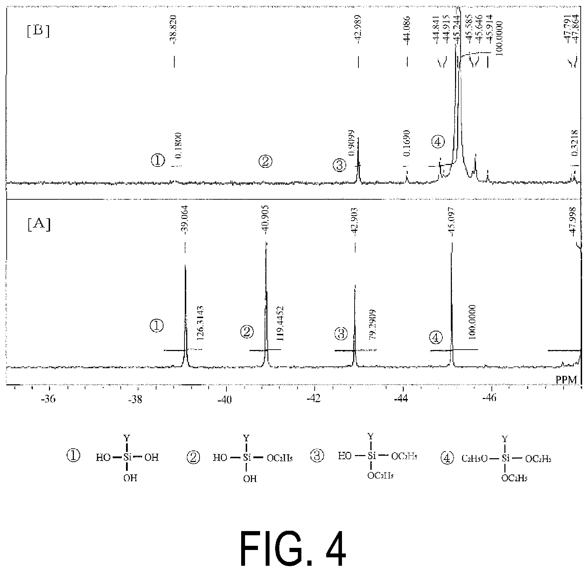

A silane coupling agent (3) was obtained in the same manner as in Example 1 except that the heating temperature was changed to 50°C and the pH of the acetic acid aqueous solution was changed to 2.67. The silane coupling agent (3) was subjected to Si-NMR measurement. The result is shown in FIG. 4(A).

### Example 4: Preparation of silane coupling agent

A silane coupling agent (4) was obtained in the same manner as in Example 1 except that the heating temperature was changed to 50°C, the heating time was changed to 4 hours, and the pH of the acetic acid aqueous solution was changed to 3.

### Example 5: Preparation of silane coupling agent

The same procedure was carried out as in Example 1 except that the heating temperature was changed to 50°C and the heating time was changed to 6 hours. As a result, a hydrolysis reaction and a polycondensation reaction proceeded with a conversion rate of 90%, and a silane coupling agent (5) was obtained.

### Example 6: Preparation of silane coupling agent

The same procedure was carried out as in Example 1 except that the water amount was changed to 3 eq and the heating time was changed to 11 hours. As a result, a hydrolysis reaction and a polycondensation reaction proceeded with a conversion rate of 78%, and a silane coupling agent (6) was obtained.

### Example 7: Preparation of silane coupling agent

The same procedure was carried out as in Example 1 except that the water amount was changed to 9 eq. As a result, a hydrolysis reaction and a polycondensation reaction proceeded with a conversion rate of 100%, and a silane coupling agent (7) was obtained.

### Example 8: Preparation of silane coupling agent

To a reaction vessel were placed 100 parts by weight of 3-glycidoxypropyltriethoxysilane and 20 parts by weight of 10 wt.% acetic acid aqueous solution and stirred at 50°C for 6 hours. The reaction solution was then concentrated at 40°C for 2 hours, PGMEA was added, and a silane coupling agent (8) was obtained.

### Example 9

To a reaction vessel were placed 100 parts by weight of 3-glycidoxypropyltriethoxysilane and 20 parts by weight of 10 wt.% acetic acid aqueous solution and stirred at 50°C for 6 hours. PGMEA was then added to the reaction solution, and a silane coupling agent (9) was obtained.

### Comparative Example 1: Preparation of silane coupling agent

A silane coupling agent (10) was obtained in the same manner as in Example 1 except that ethanol was added from the beginning of the reaction instead of adding ethanol after completion of the reaction.

That is, to a reaction vessel were placed 3-glycidoxypropyltriethoxysilane, acetic acid aqueous solution, and ethanol, and the reaction vessel was heated at 70°C for 3 hours under conditions of pH 4, 6 eq of water, and 6 eq of ethanol.

The heat treatment was then stopped, and 36.9 g of ethanol was added to 5 g of the resulting crude product, and a silane coupling agent (10) was obtained.

### Comparative Example 2

To a reaction vessel were placed 50 parts by weight of 3-glycidoxypropyltriethoxysilane, 50 parts by weight of PGMEA, and 2 parts by weight of water. The pH in the reaction vessel was 5. The reaction vessel was heated at 45°C for 30 days.

The heat treatment was then stopped, and a silane coupling agent (11) was obtained.

The silane coupling agent (11) was subjected to Si-NMR measurement. The result is shown in FIG. 4(B).

The silane coupling agents obtained in Examples 1 to 9 and Comparative Examples 1 and 2 were evaluated for storage stability by the following methods.

That is, an experiment was carried out in which the silane coupling agent was allowed to stand at room temperature, the rise value of the weight average molecular weight from immediately after the start of the experiment until 40 days after the start of the experiment were measured, and storage stability was evaluated according to the following criteria.

### Evaluation criteria

Excellent: No white precipitate was produced 40 days after the start of the experiment, and the rise value of the weight average molecular weight was 100 or less
Good: No white precipitate was produced 40 days after the start of the experiment, and the rise value of the weight average molecular weight was greater than 100 and 500 or less
Slightly poor: No white precipitate was produced 40 days after the start of the experiment, but the rise value of the weight average molecular weight was greater than 500
Poor: White precipitate was produced

The results are summarized and shown in Table 1 below.

### [Table 1]

**Table 1**

| | | Examples | | | | | | | | | Comparative Examples | |
|---|---|---|---|---|---|---|---|---|---|---|---|---|
| | | 1 | 2 | 3 | 4 | 5 | 6 | 7 | 8 | 9 | 1 | 2 |
| Silane coupling agent No. | | (1) | (2) | (3) | (4) | (5) | (6) | (7) | (8) | (9) | (10) | (11) |
| Silicon compound | Compound (I)/compound (II) | 38/62 | 38/62 | 26/74 | 90/10 | 70/30 | 22/78 | 30/70 | 5/95 | 12/88 | 99/1 | 99/1 |
| | Mw | 440 | 440 | 510 | 250 | 320 | 650 | 480 | 590 | 450 | 200 | 1000 |
| | Mw/Mn | 1.4 | 1.4 | 1.2 | 1.1 | 1.2 | 1.4 | 1.3 | 1.4 | 1.3 | 1.0 | 1.7 |
| Solvent | | Ethanol | PGMEA | Ethanol | Ethanol | Ethanol | Ethanol | Ethanol | PGMEA | PGMEA | PGMEA | PGMEA |
| Silicon compound concentration (wt.%) | | 5 | 5 | 5 | 5 | 5 | 5 | 5 | 5 | 5 | 5 | 45 |
| Storage stability | | Excellent | Good | Excellent | Excellent | Excellent | Good | Excellent | Slightly poor | Good | Good | Poor |

In addition, the silane coupling agents obtained in Examples 1 and 2 were evaluated for storage stability at 5°C or 40°C by the following method.

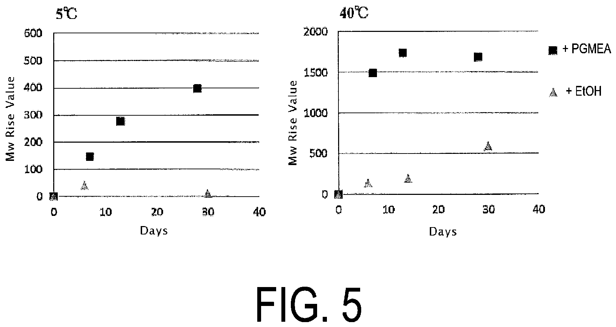

An experiment was carried out in which the silane coupling agent was allowed to stand at 5°C or 40°C, and the rise value of the weight average molecular weight from immediately after the start of the experiment until 40 days after the start of the experiment was measured. The results are shown in FIG. 5.

### Examples 10 to 18 and Comparative Examples 3 and 4

Two-part adhesives each containing any of the silane coupling agents obtained in Examples 1 to 9 and Comparative Examples 1 and 2 (the silicon compound concentration in the silane coupling agent was changed as described in Table 2 below by adding a solvent described in Table 2 below) and a curable composition (1) obtained in Preparation Example 1 below was obtained.

### Preparation Example 1

To a 300-mL flask (reaction vessel) equipped with a thermometer, a stirrer, a reflux condenser, and a nitrogen inlet tube were placed 161.5 mmol (39.79 g) of 2-(3,4-epoxycyclohexyl)ethyltrimethoxysilane, 9 mmol (1.69 g) of phenyltrimethoxysilane, and 165.9 g of acetone under a nitrogen stream, and the temperature was raised to 50°C. To the mixture thus obtained, 4.70 g of 5% potassium carbonate aqueous solution (1.7 mmol as potassium carbonate) was added dropwise over 5 minutes, and then 1700 mmol (30.60 g) of water was added dropwise over 20 minutes. No significant temperature increase occurred during the drop-wise additions. A polycondensation reaction was then carried out under a nitrogen stream for 4 hours while the temperature was maintained at 50°C.

A product in the reaction solution after the polycondensation reaction, when analyzed, had a number average molecular weight of 1900 and a molecular weight dispersity of 1.5. A ratio of the T2 form and the T3 form [T3 form/T2 form] calculated from the ²⁹Si-NMR spectrum of the product was 10.3.

The reaction solution was then cooled and washed with water until the lower layer liquid became neutral, and the upper layer liquid was collected. The solvent was then distilled off from the upper layer liquid under conditions of 1 mmHg and 40°C until the solvent amount became 25 wt.%, and a colorless transparent liquid product (epoxy group-containing polyorganosilsesquioxane) was obtained.

A curable composition (1) was obtained by mixing 100 parts by weight of the resulting epoxy group-containing polyorganosilsesquioxane, 50 parts by weight of propylene glycol monomethyl ether acetate, 0.1 parts by weight of "SAN-AID SI-150L (trade name)" (an antimony-based sulfonium salt available from Sanshin Chemical Industry Co., Ltd.), and 0.005 parts by weight of "SAN-AID SI Auxiliary Agent (trade name)" ((4-hydroxyphenyl)dimethylsulfonium methyl sulfite available from Sanshin Chemical Industry Co., Ltd.).

### Evaluation of adhesion

The two-part adhesive obtained in the examples and the comparative examples were evaluated for adhesion by the following method.

The silane coupling agent whose concentration was adjusted with a diluting solvent was applied to one side of a glass sheet (four inch, available from SCHOTT Japan Co., Ltd.) by spin coating, heated at 100°C for 15 minutes, and a silane coupling agent layer (thickness: 0.01 µm) was obtained. The curable composition (1) was applied to the surface of the resulting silane coupling agent layer by spin coating to produce a curable composition layer (thickness: 2.5 µm), and a laminate with a configuration of the glass sheet/the silane coupling agent layer/the curable composition layer was obtained.

The laminate obtained above was heated at 150°C for 30 minutes, then heated at 170°C for 30 minutes, and was used as a sample. The resulting samples (five for each sample) were evaluated by the cross-cut tape test in accordance with JIS K 5400-8.5.
Excellent (excellent adhesion): No peeling occurred in all five samples
Good (good adhesion): Peeling occurred in one or two samples
Poor (poor adhesion): Peeling occurred in three or more samples

The results are summarized and shown in Table 2 below.

### [Table 2]

**Table 2**

| | | Examples | | | | | | | | | Comparative Examples | |
|---|---|---|---|---|---|---|---|---|---|---|---|---|
| | | 10 | 11 | 12 | 13 | 14 | 15 | 16 | 17 | 18 | 3 | 4 |
| Silane coupling agent No. | | (1) | (2) | (3) | (4) | (5) | (6) | (7) | (8) | (9) | (10) | (11) |
| Solvent | | Ethanol | PGMEA | Ethanol | Ethanol | Ethanol | Ethanol | Ethanol | PGMEA | PGMEA | Ethanol | PGMEA |
| Silicon compound concentration (wt.%) | 1 | Excellent | Excellent | Excellent | Excellent | Excellent | Excellent | Excellent | Excellent | Excellent | Good | Excellent |
| | 0.5 | Excellent | Excellent | Excellent | Excellent | Excellent | Excellent | Excellent | Excellent | Excellent | Poor | Excellent |
| | 0.3 | Excellent | Excellent | Excellent | Excellent | Excellent | Excellent | Excellent | Excellent | Excellent | Poor | Poor |
| | 0.2 | Excellent | Excellent | Excellent | Excellent | Excellent | Excellent | Excellent | Excellent | Excellent | Poor | Poor |
| | 0.04 | Good | Good | Good | Good | Good | Good | Good | Excellent | Good | Poor | Poor |
| | 0.02 | Good | Good | Good | Good | Good | Good | Good | Good | Good | Poor | Poor |

### Example 19

The silane coupling agent (1) obtained in Example 1 and the curable composition (1) obtained in Preparatory Example 1 above were mixed and dissolved by changing the added amount of the silane coupling agent to give a silicon compound concentration in the silane coupling agent relative to the curable composition (1) as described in Table 3 below, and 10 g of a one-part adhesive was obtained.

### Comparative Example 5

A one-part adhesive was obtained in the same manner as in Example 19 except that the silane coupling agent (11) was used instead of the silane coupling agent (1).

### Evaluation of adhesion

The one-part adhesive obtained in Example 19 and Comparative Example 5 were evaluated for adhesion by the following method.

The resulting one-part adhesive was applied to one side of a glass sheet (four inch, available from SCHOTT Japan Co., Ltd.) by spin coating, heated at 80°C for four minutes and then heated at 100°C for two minutes to remove residual solvents. The resulting material was then heated at 150°C for 30 minutes, then heated at 170°C for 30 minutes, and a laminate with a configuration of the glass sheet/an adhesive layer was obtained.

The laminates obtained above (the number of samples: five) were evaluated by the cross-cut tape test in accordance with JIS K 5400-8.5. The evaluation criteria are the same as in the evaluation of adhesion of the two-part adhesives.

The results are summarized and shown in Table 3 below.

### [Table 3]

**Table 3**

| | | Example 19 | Comparative Example 5 |
|---|---|---|---|
| Silicon compound concentration (wt.%) | 1 | Excellent | Poor |
| | 0.1 | Excellent | Poor |
| | 0.04 | Excellent | Poor |

As a summary of the above, configurations and variations of the present disclosure will be described in addition below.
[1] A silane coupling agent containing a silicon compound below and water, and having a concentration of the silicon compound of from 0.01 to 10 wt.%:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[2] A silane coupling agent containing a silicon compound below and water, and having a concentration of the silicon compound of from 0.01 to 10 wt.%:
   the silicon compound: containing a compound (I) represented by Formula (1) and a compound represented by Formula (3), where a ratio of contents of the compound (I) to a compound (II), [compound (I)/compound (II); weight ratio], the compound (II) being a compound represented by Formula (3) and having a weight average molecular weight of from 200 to 10000 calibrated with a polystyrene standard, is from 1/99 to 95/5.
[3] The silane coupling agent according to [1] or [2], in which a content of a compound that is a polycondensate of the compound (I) (or a compound represented by Formula (3)) and has a weight average molecular weight less than 200 calibrated with a polystyrene standard is 30 wt.% or less of a total amount of the silicon compound contained in the silane coupling agent.
[4] The silane coupling agent according to [1] or [2], in which a content of a compound that is a polycondensate of the compound (I) (or a compound represented by Formula (3)) and has a weight average molecular weight greater than 10000 calibrated with a polystyrene standard is 30 wt.% or less of a total amount of the silicon compound contained in the silane coupling agent.
[5] The silane coupling agent according to [1] or [2], in which a total content of a compound that is a polycondensate of the compound (I) (or a compound represented by Formula (3)) and has a weight average molecular weight less than 200 calibrated with a polystyrene standard and a compound that is a polycondensate of the compound (I) (or a compound represented by Formula (3)) and has a weight average molecular weight greater than 10000 calibrated with a polystyrene standard is 30 wt.% or less of a total amount of the silicon compound contained in the silane coupling agent.
[6] The silane coupling agent according to any one of [1] to [5], in which a content of the compound represented by Formula (2) is 50 wt.% or less of a total amount of the silicon compound contained in the silane coupling agent.
[7] The silane coupling agent according to any one of [1] to [6], having a pH of 4 or lower.
[8] The silane coupling agent according to any one of [1] to [7], further containing a solvent with the following properties:
   the solvent: having an evaporation rate of from 10 to 400 when the evaporation rate of butyl acetate is taken as 100.
[9] The silane coupling agent according to any one of [1] to [7], further containing a solvent with the following properties:
   the solvent: having an evaporation rate of from 10 to 400 when the evaporation rate of butyl acetate is taken as 100, and an SP value of 6 to 15 at 25°C.
[10] The silane coupling agent according to any one of [1] to [7], further containing an aliphatic alcohol.
[11] The silane coupling agent according to any one of [1] to [7], further containing a monohydric aliphatic alcohol.
[12] The silane coupling agent according to any one of [1] to [7], further containing a monohydric C₂₋₆ aliphatic alcohol.
[13] The silane coupling agent according to any one of [1] to [7], further containing ethanol.
[14] The silane coupling agent according to any one of [1] to [13], having a viscosity of 1 to 300 mPa•s at 25°C and a rotation speed of 0.5 rpm.
[15] The silane coupling agent according to any one of [1] to [14], having a rise value of weight average molecular weight of 500 or less calibrated with a polystyrene standard when stored at 25°C for 30 days.
[16] The silane coupling agent according to any one of [1] to [15], having a rise value of weight average molecular weight of 2000 or less calibrated with a polystyrene standard when stored at 40°C for 30 days.
[17] The silane coupling agent according to any one of [1] to [16], in which the silane coupling agent is a surface modifier.
[18] A method of manufacturing a silane coupling agent, the method including:
   by hydrolyzing a compound represented by Formula (2) obtaining a compound represented by Formula (1) under a condition of pH 4 or lower and under conditions where, either in the absence or presence of an organic solvent, a content of the organic solvent is 0.7 parts by weight or less per part by weight of the compound represented by Formula (2); and
   by subjecting the resulting compound represented by Formula (1) to a polycondensation reaction, obtaining the silane coupling agent described in any one of [1] to [17].
[19] An adhesive containing a silicon compound below and a curable compound:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[20] The adhesive according to [19], in which a content of the silicon compound is from 0.01 to 40 parts by weight per 100 parts by weight of the curable compound.
[21] An adhesive containing a silicon compound below and an epoxy group-containing polyorganosilsesquioxane:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[22] The adhesive according to [21], in which a content of the silicon compound is from 0.01 to 40 parts by weight per 100 parts by weight of the epoxy group-containing polyorganosilsesquioxane.
[23] A three-dimensional laminate having a configuration in which a wafer and a wafer, a chip and a chip, or a wafer and a chip are laminated via the adhesive described in any one of [19] to [22].
[24] A semiconductor device provided with the three-dimensional laminate described in [23].
[25] A method of manufacturing a three-dimensional laminate, the method including manufacturing a three-dimensional laminate by bonding a wafer and a wafer, a chip and a chip, or a wafer and a wafer together using an adhesive containing a silicon compound below and a curable compound:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[26] Use of the silane coupling agent described in any one of [1] to [17] in a surface modifier.
[27] Use of a composition containing a silicon compound below and a curable compound in an adhesive:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[28] Use of a compound containing a silicon compound below and a curable compound, and having a content of the silicon compound of from 0.01 to 40 parts by weight per 100 parts by weight of the curable compound:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[29] Use of a composition containing a silicon compound below and an epoxy group-containing polyorganosilsesquioxane in an adhesive:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.
[30] Use of a composition containing a silicon compound below and an epoxy group-containing polyorganosilsesquioxane, in which a content of the silicon compound is from 0.01 to 40 parts by weight per 100 parts by weight of the epoxy group-containing polyorganosilsesquioxane:
   the silicon compound: containing a compound (I) represented by Formula (1) and a polycondensate of the compound (I), where a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5.

### Industrial Applicability

The silane coupling agent of the present disclosure can strongly adhere inorganic matter and organic matter even at low concentrations. In addition, the silane coupling agent has excellent storage stability.

Using an adhesive containing the silane coupling agent according to the present disclosure in a semiconductor chip lamination technique, such as a WOW method, a COW method, or a COC method, enables to strongly adhere and fix wafers or chips that are extremely reduced in size and thickness and manufacture a three-dimensional laminate with good yield.

## Claims

1. A silane coupling agent comprising a silicon compound defined below and water, and having a concentration of the silicon compound of from 0.01 to 10 wt.%:
the silicon compound: comprising a compound (I) represented by Formula (1) and a polycondensate of the compound (I), wherein a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5: 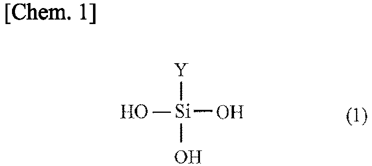
where in Formula (1), Y represents a hydrocarbon group having from 1 to 10 carbons and containing a group reactive with organic matter.

2. The silane coupling agent according to claim 1, having a pH of 4 or lower.

3. The silane coupling agent according to claim 1 or 2, further comprising a solvent with properties below:
the solvent: having an evaporation rate of from 10 to 400 when the evaporation rate of butyl acetate is taken as 100.

4. The silane coupling agent according to claim 1 or 2, further comprising a solvent with properties below:
the solvent: having an evaporation rate of from 10 to 400 when the evaporation rate of butyl acetate is taken as 100, and an SP value of 6 to 15 at 25°C.

5. The silane coupling agent according to any one of claims 1 to 4, wherein the silane coupling agent is a surface modifier.

6. A method of manufacturing a silane coupling agent, the method comprising, by hydrolyzing a compound represented by Formula (2), obtaining a compound represented by Formula (1) under a condition of pH 4 or lower and under conditions where, either in the absence or presence of an organic solvent, a content of the organic solvent is 0.7 parts by weight or less per part by weight of the compound represented by Formula (2): 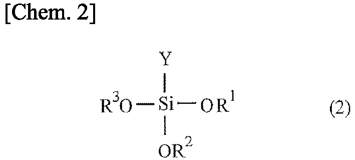
where in Formula (2), Y represents a hydrocarbon group having from 1 to 10 carbons and containing a group reactive with organic matter, and OR¹ to OR³ are the same or different and each represent a hydrolyzable group, 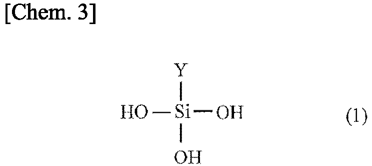
where in Formula (1), Y is the same as described above; and
the method comprising, by subjecting the resulting compound represented by Formula (1) to a polycondensation reaction, obtaining the silane coupling agent described in any one of claims 1 to 5.

7. An adhesive comprising a silicon compound below and a curable compound:
the silicon compound: comprising a compound (I) represented by Formula (1) and a polycondensate of the compound (I), wherein a ratio of contents of the compound (I) to a compound (II), [compound (I)/compound (II); weight ratio], the compound (II) being a polycondensate of the compound (I) and having a weight average molecular weight of from 200 to 10000 calibrated with a polystyrene standard, is from 1/99 to 95/5: 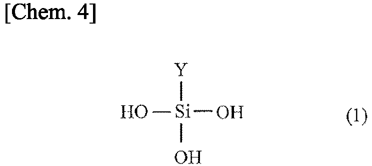
where in Formula (1), Y represents a hydrocarbon group having from 1 to 10 carbons and containing a group reactive with organic matter.

8. The adhesive according to claim 7, wherein a content of the silicon compound is from 0.01 to 40 parts by weight per 100 parts by weight of the curable compound.

9. A three-dimensional laminate having a configuration in which a wafer and a wafer, a chip and a chip, or a wafer and a chip are laminated via the adhesive described in claim 7 or 8.

10. A semiconductor device comprising the three-dimensional laminate described in claim 9.
